# FASCICULE DE BREVET EUROPEEN

(11) **EP 1 959 478 B1**
(45) Date de publication et mention de la délivrance du brevet: **17.08.2011**
(21) Numéro de dépôt: 08354013.8
(22) Date de dépôt: 07.02.2008
(51) Int. Cl.: H01L 21/02, H01L 21/18, H01L 21/306

(54) **Procédé de collage moléculaire avec nettoyage à l'acide fluorhydrique en phase vapeur et rinçage à l'eau déionisée**
Molekülbindungsverfahren mit Flusssäure-Reinigung in der Dampfphase und Abspülen mit entionisiertem Wasser
Molecular gluing method using hydrofluoric acid in vapour phase for cleaning and deionised water for rinsing

(30) Priorité: 19.02.2007 FR 0701168
(43) Date de publication de la demande: 20.08.2008
(73) Titulaire: Commissariat à l'Énergie Atomique et aux Énergies Alternatives, 75015 Paris (FR)
(72) Inventeur: Fournel, Frank, 38190 Villard-Bonnot (FR); Moriceau, Hubert, 38120 Saint Egreve (FR); Morales, Christophe, 38220 St Pierre de Mesage (FR); Perreau, Pierre, 38000 Grenoble (FR)
(74) Mandataire: Hecké, Gérard

(56) Documents cités:
- US-A- 5 451 547
- US-B1- 6 740 247

## Description

### Domaine technique de l'invention

L'invention concerne un procédé de collage tel que décrit dans les revendications.

### État de la technique

Le principe du collage par adhérence moléculaire est basé sur la mise en contact direct de deux surfaces, sans utilisation d'un matériau spécifique tel qu'une colle, une cire, un métal à basse température de fusion... Les surfaces destinées à être mises en contact peuvent être hydrophiles ou hydrophobes.

Des surfaces hydrophobes peuvent, par exemple, être les surfaces libres de deux plaques de silicium monocristallin. Le collage par adhérence moléculaire de telles plaques est, par exemple, utilisé lorsque l'on souhaite obtenir une conduction électrique élevée entre les deux plaques ou lorsque l'on souhaite obtenir un joint de grains cristallins de très grande dimension.

Le procédé de collage par adhérence moléculaire nécessite, par ailleurs, que les surfaces à coller soient suffisamment lisses, exemptes de particules ou de contamination, qu'elles présentent une chimie de surface adaptée et qu'elles soient suffisamment rapprochées pour permettre d'initier un contact.

Dans ce cas, les forces attractives entre les deux surfaces sont assez élevées pour provoquer l'adhérence moléculaire. Les collages sont, généralement, réalisés à température et à pression ambiante, après un nettoyage chimique des surfaces. De plus, le renforcement des énergies de collage peut être réalisé par un traitement thermique ultérieur.

Dans le cas du collage moléculaire des surfaces hydrophobes, les surfaces doivent être exemptes d'oxyde. L'opération de nettoyage, réalisée avant la mise en contact des deux surfaces, permet de supprimer l'oxyde desdites surfaces. Ainsi, pour des plaques en silicium, l'oxyde natif présent à la surface libre desdites plaques est, en général, supprimé en trempant lesdites plaques dans une solution liquide, éventuellement diluée, d'acide fluorhydrique (noté HF). La solution d'acide fluorhydrique permet en effet d'attaquer chimiquement (par gravure) l'oxyde natif, rendant, ainsi, la surface libre des plaques exempte d'oxyde et donc hydrophobe. De plus, dans le cas du silicium, l'acide fluorhydrique passive les liaisons terminales du cristal par des atomes d'hydrogène, rendant la surface hydrophobe et compatible avec un collage moléculaire puisque les deux surfaces en silicium s'attirent quand elles sont suffisamment rapprochées.

Cependant, une telle opération de nettoyage des plaques ou de désoxydation n'est pas satisfaisante. En effet, l'interface des deux plaques collées par adhérence moléculaire, après une étape de nettoyage à l'acide fluorhydrique liquide n'est pas d'une très grande qualité, notamment du point de vue électrique et mécanique.

Plus particulièrement, des plaques en silicium présentent initialement une rugosité RMS, mesurée par microscopie à force atomique (AFM), inférieure à 0,2nm. Lorsqu'elles subissent une opération de nettoyage d'une durée de 10 minutes environ, dans une solution aqueuse comprenant 10% d'acide fluorhydrique pendant 10 minutes (pH~1,2), elles présentent une rugosité RMS de 0,24nm et pour une même durée de nettoyage mais avec une solution aqueuse comprenant 1% de HF (pH~1,7), la rugosité des surfaces libres des plaques de silicium est de l'ordre de 0,32nm. L'augmentation de rugosité des surfaces libres desdites plaques peut être attribuée à la présence d'oxygène dissout dans les solutions de HF. Cet oxygène dissous oxyde localement le silicium. L'oxyde ainsi formé est enlevé par HF, ce qui crée des irrégularités en surface et donc une rugosité plus élevée. Or, une rugosité élevée des surfaces libres des plaques peut provoquer une augmentation de piégeages de charges à l'interface entre les deux plaques collées par adhérence moléculaire et donc diminuer la qualité électrique de ladite interface.

De plus, une telle opération de nettoyage à l'acide fluorhydrique liquide provoque également une contamination particulaire des surfaces libres, nuisible pour le collage ultérieur des plaques et pour la qualité mécanique de l'interface entre les deux plaques, après collage.

### Objet de l'invention

L'invention a pour but un procédé de collage par adhérence moléculaire de deux surfaces libres, respectivement de premier et second substrats, remédiant aux inconvénients de l'art antérieur.

Plus particulièrement, l'invention a pour but d'obtenir le collage par adhérence moléculaire des premier et second substrats, avec une interface de collage de très bonne qualité, notamment du point de vue électrique et mécanique.

Selon l'invention, ce but est atteint par les revendications annexées. En particulier, ce but est atteint par le fait que l'étape de nettoyage est réalisée avec de l'acide fluorhydrique en phase vapeur et par le fait qu'une étape de rinçage à l'eau déionisée est réalisée entre l'étape de nettoyage et l'étape de mise en contact, pendant une durée inférieure ou égale à 30 secondes.

Selon un développement de l'invention, les premier et second substrats sont respectivement constitués par les composés SiₓGe₁₋ₓ et Si_{y}Ge_{1-y} avec x et y compris entre 0 et 1.

### Description de modes particuliers de réalisation

Le collage par adhérence moléculaire des surfaces libres de premier et second substrats, par exemple formés par des plaques de silicium monocristallin, comporte au moins successivement :
- une étape de nettoyage des surfaces libres à l'acide fluorhydrique en phase vapeur,
- une étape de rinçage desdites surfaces libres à l'eau déionisée d'une durée inférieure ou égale à 30 secondes
- et une étape de mise en contact desdites surfaces libres.

L'étape de nettoyage des surfaces libres permet, plus particulièrement, de désoxyder les surfaces libres des substrats et de les rendre hydrophobes. Comme selon l'art antérieur, cette étape est réalisée à l'aide d'acide fluorhydrique (HF), mais celui-ci se trouve dans le cadre de l'invention sous forme vapeur et non liquide.

Le nettoyage de substrat par attaque à l'acide fluorhydrique en phase gazeuse a déjà été proposé, notamment pour diminuer la contamination particulaire de la surface dudit substrat. À titre d'exemple, la demande US-A-2005-0003669 décrit un procédé de nettoyage de substrats semiconducteurs, à l'aide de vapeur d'acide fluorhydrique anhydre et de vapeur d'eau à une température de substrat supérieure ou égale à 40°C.

Cependant, il est connu que le traitement des plaques de silicium par l'acide fluorhydrique en phase vapeur ne permet pas d'obtenir un collage moléculaire à température et à pression ambiante. A titre d'exemple, les surfaces libres de deux plaques en silicium présentant une rugosité RMS de 0,2nm sont nettoyées dans une solution à base d'un mélange péroxyde ammonium également connu sous le nom d'APM et débarrassées de leurs particules par nettoyage acoustique par mégason. Les deux surfaces sont alors hydrophiles et compatibles avec un collage moléculaire. Par contre, si un nettoyage supplémentaire est réalisé avec l'acide fluorhydrique en phase vapeur, pendant 3 minutes, on constate que les deux surfaces deviennent alors hydrophobes mais qu'elles ne sont plus compatibles avec un collage moléculaire et ce malgré l'absence de particules mesurées au moyen d'un appareil de détection de particules tel qu'un équipement de détection de particules nommé Surfscan SP1 de la société Tencor.

Or, de manière surprenante, il a été trouvé qu'en réalisant, après une étape de nettoyage à l'acide fluorhydrique en phase vapeur, une étape de rinçage desdites surfaces libres à l'eau déionisée pendant une courte durée, inférieure ou égale à 30 secondes, le collage moléculaire des deux surfaces devenait possible.

Le rinçage à l'eau a déjà été utilisé, par le passé, après un nettoyage à l'acide fluorhydrique en phase vapeur, dans d'autres domaines (US-A-2005-0003669). Il était utilisé pour éliminer desdites surfaces les traces éventuelles de résidus néfastes pour les procédés microélectroniques ultérieurs. De telles traces de résidus provenaient de la condensation d'une partie des sous-produits issus de l'attaque de l'oxyde par la vapeur d'acide fluorhydrique. Or, une telle étape de rinçage à l'eau n'était a priori pas envisageable dans le domaine du collage moléculaire de surfaces hydrophobes. En effet, l'emploi d'eau diminue généralement le caractère hydrophobe des surfaces. Or, dans le domaine du collage moléculaire de surfaces hydrophobes, les surfaces doivent être le plus hydrophobe possible et la présence d'eau ou d'oxygène sur lesdites surfaces est généralement minimisée pour maintenir le caractère hydrophobe desdites surfaces.

Un rinçage à l'eau, pendant une durée de 0.5 à 1 heure, a déjà aussi été utilisé, après un nettoyage à l'acide fluorhydrique en phase vapeur, dans un procédé de collage par adhérence moléculaire de deux surfaces libres, respectivement de premier et second substrats (US 5 451 547 A).

Malgré de tels préjugés, la préparation de deux surfaces de substrats, par exemple en silicium, en utilisant de l'acide fluorhydrique sous forme vapeur et un rinçage à l'eau déionisée pendant une durée inférieure ou égale à 30 secondes, autorise le collage moléculaire des deux surfaces ainsi préparées, à température ambiante et à pression ambiante. En effet, il a été constaté que pour minimiser l'hydrophilisation des surfaces par exemple en silicium et pour assurer un collage de bonne qualité, le temps de rinçage devait être inférieur ou égal à 30 secondes, avantageusement inférieur ou égal à 20 secondes et même de préférence inférieur ou égal à 10 secondes. Une telle durée permet, alors, de conserver les surfaces hydrophobes. De plus, l'interface de collage obtenue est de très bonne qualité, notamment du point de vue électrique et mécanique. Les surfaces desdits substrats présentent, en particulier, une rugosité minimale, ce qui permet de diminuer au maximum les piégeages de charge à l'interface et donc d'augmenter la qualité électrique de l'interface. Enfin, les surfaces présentent un taux très faible de particules mesuré avec un appareil de détection de particules tel qu'un appareil de type surfscan SP1, malgré le rinçage à l'eau désionisée.

Le rinçage peut, par exemple, être réalisé par immersion des plaques dans un récipient contenant de l'eau déionisée et retrait desdites plaques dès que l'immersion complète a été obtenue. L'hydrophobie des surfaces peut être vérifiée par la mesure de l'angle de mouillage d'une goutte d'eau. Avec un rinçage de 30s, l'angle de contact est au-dessus de 70°, ce qui est équivalent avec l'angle de mouillage d'une surface traitée avec de l'acide fluorhydrique liquide à 1%.

À titre d'exemple, deux plaques de silicium ayant chacune une surface libre recouverte, par exemple, d'un oxyde natif, subissent un traitement dans une vapeur d'acide fluorhydrique pendant un temps d'au moins quelques secondes. La vapeur d'acide fluorhydrique est, préférentiellement, générée à partir d'une solution d'acide fluorhydrique, éventuellement diluée. À titre d'exemple, la solution peut être une solution aqueuse comportant 49% d'acide fluorhydrique. De plus, la vapeur peut être obtenue et/ou utilisée pure ou diluée dans un ou plusieurs autre(s) gaz, tels que l'azote, l'argon, l'alcool iso-propylique...

Une telle étape de nettoyage permet de désoxyder les surfaces des plaques et donc de les rendre hydrophobes. De plus, il a été constaté que la rugosité des surfaces ainsi nettoyées est moins élevée que celle de surfaces traitées avec de l'acide fluorhydrique en phase liquide. Ainsi, une surface de silicium présentant une rugosité RMS de 0,2nm conserve la même rugosité après une attaque de 3 minutes avec de l'acide fluorhydrique en phase vapeur alors que cette rugosité passe à 0,32nm avec une attaque de 1 minute avec de l'acide fluorhydrique en phase liquide à 1 %.

La durée de l'étape de nettoyage est, en général, fonction de la vitesse de gravure de l'oxyde présent à la surface des plaques à nettoyer. Cependant, dans certains cas, il peut être intéressant d'augmenter légèrement la durée de l'étape de nettoyage, de manière à améliorer la qualité du collage moléculaire. À titre d'exemple, si la durée nécessaire pour attaquer un oxyde natif de silicium et retirer la totalité du film d'oxyde natif est de l'ordre de 30 secondes, il peut être avantageux de prolonger l'attaque par l'acide fluorhydrique en phase vapeur, pendant quelques minutes et, par exemple, avantageusement pendant 3 minutes, sans endommager la surface en terme de rugosité. Le prolongement de l'attaque correspond à une sur-gravure permettant de s'affranchir d'une certaine inhomogénéité d'épaisseur de l'oxyde et de s'assurer que l'ensemble des liaisons de surface est passivé par des atomes d'hydrogène, maximisant ainsi l'hydrophobicité des surfaces.

Un rinçage desdites surfaces est ensuite effectué avec de l'eau déionisée, de grande qualité pendant une durée inférieure ou égale à trente secondes. Le contact du silicium avec l'eau se faisant sans présence d'acide fluorhydrique, l'étape de rinçage à l'eau n'a pas d'effet sur la rugosité ni sur la contamination particulaire desdites surfaces comme dans le cas de l'utilisation d'une solution liquide diluée en HF. Cette étape de rinçage rend alors les surfaces compatibles avec un collage moléculaire. Sans cette étape, les surfaces ne colleraient pas, bien qu'elles satisfassent aux critères habituels de contamination particulaire (mesurée avec un appareil de détection de particules comme un surfscan SP1) et de rugosité nécessaire normalement au collage moléculaire.

À titre d'exemple, des mesures comparatives de la densité de particules ont été réalisées sur trois plaques en silicium de 200nm de diamètre : la première plaque est neuve, la seconde plaque est nettoyée avec de l'acide fluorhydrique en phase vapeur et rincée à l'eau déionisée et la troisième plaque est nettoyée, selon l'art antérieur, à l'aide d'une solution d'acide fluorhydrique.

Les mesures ont été réalisées à l'aide d'un équipement de détection de particules Surfscan SP1, de manière à mesurer la densité de particules présentes sur la surface de chaque plaque et d'une taille par exemple supérieure à 0,12µm.

Il a été constaté que la densité de particules reste sensiblement constante pour les première et seconde plaques, c'est-à-dire respectivement avant et après le traitement à l'acide fluorhydrique en phase vapeur et le rinçage à l'eau déionisée. La densité est, par exemple, de l'ordre d'une quinzaine de particules. Le traitement à l'acide fluorhydrique et le rinçage à l'eau déionisée ne provoque donc pas une augmentation de la densité de particules contaminante, contrairement au nettoyage réalisé à l'aide d'une solution d'acide fluorhydrique (densité de particules de l'ordre d'une centaine de particules). Au contraire, la densité de particules reste sensiblement constante et, dans certains cas tels que celui d'une plaque de silicium présentant une couche d'oxyde mince (épaisseur <10nm) et une certaine densité de particules initiale, la densité de particules peut même être diminuée.

Le procédé de collage peut également concerner un substrat en silicium et un substrat en germanium ou bien deux substrats en germanium et plus généralement le collage d'un substrat SiₓGe₁₋ₓ avec un substrat Si_{y}Ge_{1-y} avec x et y compris entre 0 et 1.

## Revendications

1. Procédé de collage par adhérence moléculaire de deux surfaces libres, respectivement de premier et second substrats et comprenant au moins successivement :
- une étape de nettoyage des deux surfaces libres à l'acide fluorhydrique en phase vapeur, rendant lesdites surfaces hydrophobes, - une étape de rinçage à l'eau déionisée,
- et une étape de mise en contact des deux surfaces libres,
**caractérisé en ce que** étape de rinçage à l'eau déionisée est réalisée pendant une durée inférieure ou égale à 30 secondes.

2. Procédé selon la revendication 1, **caractérisé en ce que** les premier et second substrats sont respectivement constitués par les composés SiₓGe₁₋ₓ et Si_{y}Ge_{1-y} avec x et y compris entre 0 et 1.

3. Procédé selon l'une des revendications 1 et 2, **caractérisé en ce que** l'acide fluorhydrique en phase vapeur est pur.

4. Procédé selon l'une des revendications 1 et 2, **caractérisé en ce que** l'acide fluorhydrique en phase vapeur est mélangé à au moins un autre gaz.

5. Procédé selon la revendication 4, **caractérisé en ce que** l'autre gaz est choisi parmi l'azote, l'argon et l'alcool isopropylique.

## Claims

1. Method for molecular bonding of two free surfaces respectively of a first substrate and a second substrate and comprising at least successively:
- a cleaning step of the two free surfaces with hydrofluoric acid in vapor phase, making said surfaces hydrophobic,
- a rinsing step with deionised water,
- and a step of bringing the two free surfaces into contact,
**characterized in that** the rinsing step with deionized water is performed for a time less than or equal to 30 seconds.

2. Method according to claim 1, **characterized in that** the first and second substrates are respectively formed by the compounds SiₓGe₁₋ₓ and Si_{y}Ge_{1-y} with x and y comprised between 0 and 1.

3. Method according to one of claims 1 and 2, **characterized in that** the hydrofluoric acid in vapor phase is pure.

4. Method according to one of claims 1 and 2, **characterized in that** the hydrofluoric acid in vapor phase is mixed with at least one other gas.

5. Method according to claim 4, **characterized in that** the other gas is chosen from nitrogen, argon and isopropyl alcohol.

## Patentansprüche

1. Verfahren zum Verkleben von zwei freien Flächen eines ersten bzw. eines zweiten Substrats durch molekulare Haftung, das wenigstens nacheinander umfasst:
- einen Schritt zum Reinigen der beiden freien Flächen mittels Flusssäure in der Dampfphase, was die Flächen hydrophob macht,
- einen Spülschritt mit entionisiertem Wasser und
- einen Schritt des Inkontaktbringens der beiden freien Flächen,
**dadurch gekennzeichnet, dass** der Spülschritt mit entionisiertem Wasser über eine Zeitdauer von weniger als oder gleich 30 Sekunden durchgeführt wird.

2. Verfahren nach Anspruch 1, **dadurch gekennzeichnet, dass** das erste und das zweite Substrat aus den Verbindungen SiₓGe₁₋ₓ bzw. Si_{y}Ge_{1-y}, mit x und y zwischen 0 und 1, bestehen.

3. Verfahren nach einem der Ansprüche 1 und 2, **dadurch gekennzeichnet, dass** die Flusssäure in der Dampfphase rein ist.

4. Verfahren nach einem der Ansprüche 1 und 2, **dadurch gekennzeichnet, dass** die Flusssäure in der Dampfphase mit wenigstens einem weiteren Gas gemischt ist.

5. Verfahren nach Anspruch 4, **dadurch gekennzeichnet, dass** das andere Gas aus Stickstoff, Argon und Isopropylalkohol ausgewählt ist.
